(19) Europäisches Patentamt
European Patent Office
Office européen des brevets

(11) Veröffentlichungsnummer: **0 425 976 A2**

(12) **EUROPÄISCHE PATENTANMELDUNG**

(21) Anmeldenummer: **90120269.7**

(22) Anmeldetag: **23.10.90**

(51) Int. Cl.5: **C09B 23/10**, //G03F7/031, G03G5/09

(30) Priorität: **02.11.89 DE 3936538**

(43) Veröffentlichungstag der Anmeldung:
**08.05.91 Patentblatt 91/19**

(84) Benannte Vertragsstaaten:
**CH DE FR GB IT LI**

(71) Anmelder: **BASF Aktiengesellschaft**
**Carl-Bosch-Strasse 38**
**W-6700 Ludwigshafen(DE)**

(72) Erfinder: **Martin, Hans-Dieter, Prof. Dr.**
**Haafstrasse 13**
**W-8700 Wuerzburg(DE)**
Erfinder: **Albert, Bernhard, Dr.**
**Rietburgstrasse 13**
**W-6701 Maxdorf(DE)**
Erfinder: **Kessel, Knut, Dr.**
**An den Bleichen 1**
**W-4030 Ratingen 1(DE)**

(54) **Cycloalkylidenfarbstoffe.**

(57) Cycloalkylidenfarbstoffe der Formel

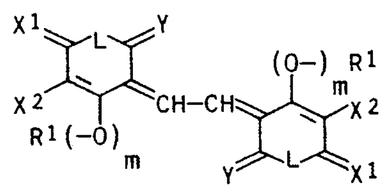 ,

in der
m 0 oder 1,
L eine chemische Bindung oder gegebenenfalls substituiertes $C_1$-$C_2$-Alkylen,
$R^1$ Wasserstoff, $C_1$-$C_{20}$-Alkyl, das gegebenenfalls durch Phenyl substituiert ist, gegebenenfalls substituiertes Phenyl, Naphthyl oder $C_3$-$C_7$-Cycloalkyl,
Y Sauerstoff oder zweimal Wasserstoff,
$X^1$ Sauerstoff und
$X^2$ $C_1$-$C_8$-Alkanoyloxy, gegebenenfalls substituiertes Benzoyloxy, $C_1$-$C_4$-Trialkylsilyloxy oder einen Rest der Formel $OR^1$ oder $NR^2R^3$, wobei $R^1$ die obengenannte Bedeutung besitzt und $R^2$ und $R^3$ unabhängig voneinander jeweils für $C_1$-$C_{20}$-Alkyl, das gegebenenfalls durch Phenyl substituiert ist, gegebenenfalls substituiertes Phenyl, Naphthyl oder $C_3$-$C_7$-Cycloalkyl oder $R^2$ und $R^3$ zusammen mit dem sie verbindenden Stickstoffatom für einen gesättigten heterocyclischen Rest oder einer der beiden Reste $R^2$ und $R^3$ auch für Wasserstoff stehen, oder $X^1$ und $X^2$ zusammen einen Rest der Formel

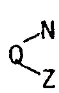

bedeuten, worin

EP 0 425 976 A2

Z für Sauerstoff, Schwefel oder $NR^2$, wobei $R^2$ die obengenannte Bedeutung besitzt, und Q für einen carbocyclischen oder heterocyclischen Ring, an dem die Substituenten N und Z benachbarte Ringpositionen einnehmen, stehen.

## CYCLOALKYLIDENFARBSTOFFE

Die vorliegende Erfindung betrifft Cycloalkylidenfarbstoffe der Formel I

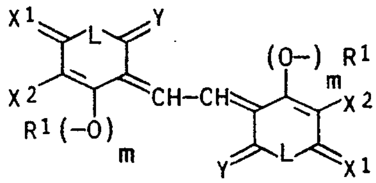

(I),

in der

m 0 oder 1,

L eine chemische Bindung oder $C_1$-$C_2$-Alkylen, das gegebenenfalls durch $C_1$-$C_4$-Alkyl ein- oder zweifach substituiert ist,

$R^1$ Wasserstoff, $C_1$-$C_{20}$-Alkyl, das gegebenenfalls durch Phenyl substituiert ist, gegebenenfalls substituiertes Phenyl, Naphthyl oder $C_3$-$C_7$-Cycloalkyl,

Y Sauerstoff oder zweimal Wasserstoff,

$X^1$ Sauerstoff und

$X^2$ $C_1$-$C_8$-Alkanoyloxy, gegebenenfalls substituiertes Benzoyloxy, $C_1$-$C_6$-Trialkylsilyloxy oder einen Rest der Formel $OR^1$ oder $NR^2R^3$, wobei $R^1$ die obengenannte Bedeutung besitzt und $R^2$ und $R^3$ gleich oder verschieden sind und unabhängig voneinander jeweils für $C_1$-$C_{20}$-Alkyl, das gegebenenfalls durch Phenyl substituiert ist, gegebenenfalls substituiertes Phenyl, Naphthyl oder $C_3$-$C_7$-Cycloalkyl oder $R^2$ und $R^3$ zusammen mit dem sie verbindenden Stickstoffatom für einen 5- oder 6-gliedrigen gesattigten heterocyclischen Rest, der gegebenenfalls weitere Heteroatome aufweist, oder einer der beiden Reste $R^2$ und $R^3$ auch für Wasserstoff stehen, oder $X^1$ und $X^2$ zusammen einen Rest der Formel

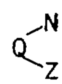

bedeuten, worin

Z für Sauerstoff, Schwefel oder $NR^2$, wobei $R^2$ die obengenannte Bedeutung besitzt, und

Q für einen 5- oder 6-gliedrigen gesättigten oder aromatischen, carbocyclischen oder heterocyclischen Ring, an dem die Substituenten N und Z benachbarte Ringpositionen einnehmen, stehen.

Aus Helv. Chim. Acta Band 64, Seiten 2665 bis 2680, 1981, sind Verbindungen bekannt, die sich von Chinoxalin ableiten und über den heterocyclischen Ring verdoppelt sind.

Aufgabe der vorliegenden Erfindung war es, neue Cycloalkylidenfarbstoffe bereitzustellen, die in einfacher Weise herstellbar sein und über vorteilhafte anwendungstechnische Eigenschaften verfügen sollten.

Demgemäß wurden die eingangs näher bezeichneten Cycloalkylidenfarbstoffe der Formel I gefunden.

Alle in der obengenannten Formel I auftretenden Alkylgruppen können sowohl geradkettig als auch verzweigt sein.

Wenn in der obengenannten Formel I substituierte Phenylgruppen auftreten, so können als Substituenten z.B. $C_1$-$C_4$-Alkyl, $C_1$-$C_4$-Alkoxy oder Halogen in Betracht kommen.

Reste L sind z.B. Methylen, Ethylen, Ethyliden, Prop-1-yliden, Prop-2-yliden, 1,2-Propylen, 1,2-Butylen, 2,3-Butylen, Pent-3-yliden oder 3,4-Hexylen.

Reste $R^1$, $R^2$ und $R^3$ sind z.B. Methyl, Ethyl, Propyl, Isopropyl, Butyl, Isobutyl, sec-Butyl, Pentyl, Isopentyl, Neopentyl, tert-Pentyl, Hexyl, 2-Methylpentyl, Heptyl, Octyl, 2-Ethylhexyl, Nonyl, Decyl, Undecyl, Dodecyl, Tridecyl, Tetradecyl, Pentadecyl, Hexadecyl, Heptadecyl, Octadecyl, Nonadecyl, Eicosyl, Benzyl, 1- oder 2-Phenylethyl, Phenyl, 2-, 3- oder 4-Methylphenyl, 2,4-Dimethylphenyl, 2-, 3- oder 4-Methoxyphenyl, 2,4-Dimethoxyphenyl, 2-, 3- oder 4-Chlorphenyl, 2,6-Dichlorphenyl, 2-, 3- oder 4-Bromphenyl, Naphth-1-yl, Naphth-2-yl, Cyclopropyl, Cyclobutyl, Cyclopentyl, Cyclohexyl oder Cycloheptyl.

Wenn $R^2$ und $R^3$ zusammen mit dem sie verbindenden Stickstoffatom einen 5- oder 6-gliedrigen

gesättigten heterocyclischen Rest bedeuten, so kann dabei z.B. Pyrrolidino, Piperidino, Morpholino, Piperazino oder N-($C_1$-$C_4$-Alkyl)piperazino in Betracht kommen.

Reste $X^2$ sind z.B. Formyloxy, Acetyloxy, Propionyloxy, Butyryloxy, Isobutyryloxy, Pentanoyloxy, Hexanoyloxy, Heptanoyloxy, Octanoyloxy, 2-Ethylhexanoyloxy, Benzoyloxy, 2-Methylbenzoyloxy, 2-Methoxybenzoyloxy, 2-Chlorbenzoyloxy, Trimethylsilyloxy, Triethylsilyloxy, Tripropylsilyloxy, Triisopropylsilyloxy, Tributylsilyloxy, Tripentylsilyloxy oder Trihexylsilyloxy.

Wenn $X^1$ und $X^2$ zusammen einen Rest der Formel

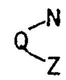

bedeuten, so kann dabei z.B.

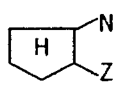 , 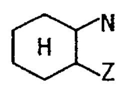 , 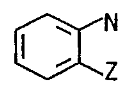 , 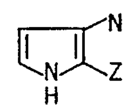

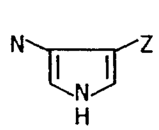 , 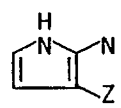 , 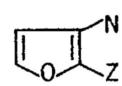 , 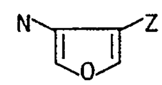

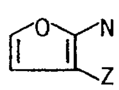 , 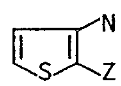 , 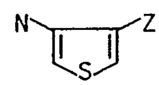 , 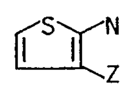 ,

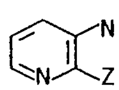 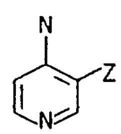 , 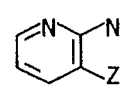 , 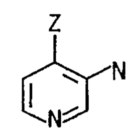 ,

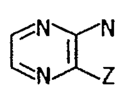 , 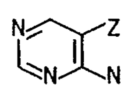 oder 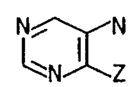 ,

in Betracht kommen, wobei diese Ringssysteme noch durch $C_1$-$C_{10}$-Alkyl, $C_1$-$C_{10}$-Alkoxy, Nitro, Amino, $C_1$-$C_4$-Mono- oder Dialkylamino, Pyrrolidino, Piperidino, Morpholino, Piperazino, N-($C_1$-$C_4$-Alkyl)piperazino oder Halogen ein- oder mehrfach substituiert sein können.

Bevorzugt sind Cycloalkylidenfarbstoffe der Formel I, in der L eine chemische Bindung oder Prop-2-yliden bedeutet.

Besonders bevorzugt sind Cycloalkylidenfarbstoffe der Formel II

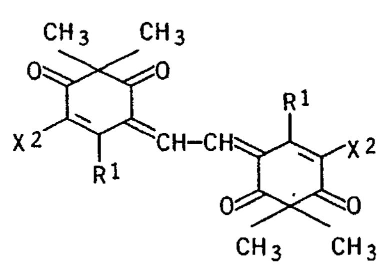 (II),

in der

$R^1$ Wasserstoff, $C_1$-$C_{10}$-Alkyl, das gegebenenfalls durch Phenyl substituiert ist, Phenyl oder Naphthyl bedeutet und
$X^2$ die obengenannte Bedeutung besitzt.

Weiterhin besonders bevorzugt sind Cycloalkylidenfarbstoffe der Formel III

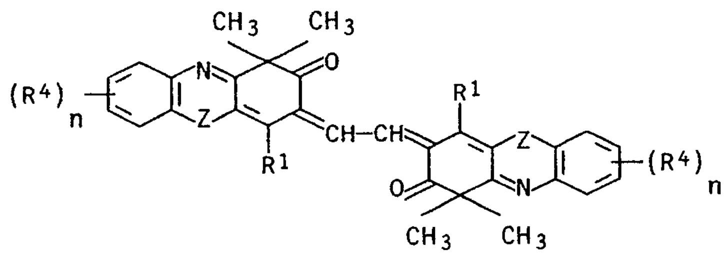

(III),

in der
n 1, 2, 3 oder 4,
$R^1$ Wasserstoff, $C_1$-$C_{10}$-Alkyl, das gegebenenfalls durch Phenyl substituiert ist, Phenyl oder Naphthyl und
$R^4$ $C_1$-$C_{10}$-Alkyl, $C_1$-$C_{10}$-Alkoxy, Nitro, Amino, $C_1$-$C_4$-Mono- oder Dialkylamino, Pyrrolidino, Piperidino, Morpholino, Piperazino, N-($C_1$-$C_4$-Alkyl)piperazino oder Halogen bedeuten und
Z die obengenannte Bedeutung besitzt.

Ganz besonders bevorzugt sind Cycloalkylidenfarbstoffe der Formel I, II oder III, wobei $R^1$ Wasserstoff bedeutet und in Formel I m gleich 0 ist.

Weiterhin ganz besonders bevorzugt sind Cycloalkylidenfarbstoffe der Formel I oder II, wobei $X^2$ Hydroxy, $C_1$-$C_8$-Alkoxy, $C_2$-$C_4$-Alkanoyloxy, Benzoyloxy, Trimethylsilyloxy, $C_1$-$C_8$-Monoalkylamino, Cyclopropylamino, Cyclopentylamino, Cyclohexylamino, Benzylamino, Phenylethylamino, Phenylamino, 2-, 3- oder 4-Methylphenylamino, Naphth-1-ylamino oder Naphth-2-ylamino bedeutet.

Weiterhin ganz besonders bevorzugt sind Cycloalkylidenfarbstoffe der Formel III, in der
Z für $C_1$-$C_8$-Alkylimino, Cyclopropylimino, Cyclopentylimino, Cyclohexylimino, Benzylimino, Phenylethylimino, Phenylimino, 2-, 3- oder 4-Methylphenylimino, Naphth-1-ylimino oder Naphth-2-ylimino steht.

Die neuen Cycloalkylidenfarbstoffe der Formel I können z.B. durch Behandlung der Methylverbindungen der Formel IV

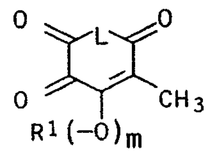

(IV),

in der
L, $R^1$ und m jeweils die obengenannte Bedeutung besitzen, zunächst mit wäßrigen Säuren bei einer Temperatur von 20 °C bis zum Siedepunkt des Reaktionsgemisches und anschließend, nach Zwischenisolierung, mit Verbindungen der Formel V
$X^3$-Hal (V),
in der
$X^3$ $C_1$-$C_8$-Alkanoyl, gegebenenfalls substituiertes Benzoyl oder $C_1$-$C_6$-Trialkylsilyl und
Hal Halogen
bedeutet, erhalten werden. Anstelle der Carbonsäurehalogenide können dabei auch deren Anhydride verwendet werden.

Geeignete wäßrige Säuren sind z.B. wäßrige Mineralsäuren oder wäßrige organische Säuren, wie Salzsäure, wäßrige Schwefelsäure, wäßrige p-Toluolsulfonsäure, wäßrige Trifluoressigsäure, wäßrige Ameisensäure oder wäßrige Oxalsäure. Der Wassergehalt liegt dabei im allgemeinen bei 5 bis 95 Gew.-%.

Nach einer Reaktionsdauer, die im allgemeinen 0,5 bis 24 Stunden beträgt, wird das Reaktionsgemisch nach an sich bekannten Methoden aufgearbeitet (z.B. Abfiltrieren des Zielprodukts, gegebenenfalls nach Einengen oder Verdünnen des Reaktionsgemisches mit Wasser).

Die Acylierung oder Silylierung erfolgt nach an sich bekannten Methoden. Die Reinigung der resultierenden Cycloalkylidenfarbstoffe I kann durch Umkristallisation oder mittels chromatographischer Methoden

erfolgen.

Diejenigen Cycloalkylidenfarbstoffe der Formel I, in der $X^2$ den Rest $NR^2R^3$ bedeutet, können vorteilhaft durch Umsetzung der Methylverbindung IV mit Aminen der Formel VI

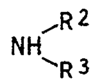

(V),

in der $R^2$ und $R^3$ jeweils die obengenannte Bedeutung besitzen, erhalten werden.

Die Umsetzung wird zweckmäßig in organischen Säuren, z.B. Ameisensäure, Essigsäure, Trifluoressigsäure, p-Toluolsulfonsäure oder Methansulfonsäure, gegebenenfalls in Anwesenheit von Verdünnungsmitteln, wie Wasser, Dioxan, Tetrahydrofuran oder niederen Alkoholen, vorgenommen.

Die Temperatur liegt im allgemeinen bei 20° C bis zum Siedepunkt des Reaktionsgemisches.

Methylverbindung IV und Amin V werden üblicherweise im Molverhältnis 3:1 bis 1:3 eingesetzt.

Nach einer Reaktionsdauer, die im allgemeinen 0,5 bis 24 Stunden beträgt, wird, wie oben ausgeführt, aufgearbeitet.

Die erfindungsgemäßen Farbstoffe wirken als Sensibilisatoren zur Initiierung von Photopolymerisationen oder als Sensibilisatoren in elektrophotographischen Kopierschichten.

In Gegenwart von Sauerstoff sind sie in der Lage, bei Bestrahlung Singulett-Sauerstoff zu bilden und eignen sich daher auch zur photodynamischen Therapie von Tumoren.

Die folgenden Beispiele sollen die Erfindung näher erläutern.

Beispiel 1

2,6,6-Trimethylcyclohex-2-en-1,4-dion

In einen 1 l Dreihalskolben, bestückt mit Gaseinleitungsfritte, Rührer und Intensivkühler gab man: 350 ml Toluol, 350 g Isophoron, 11,4 g $H_3[P(Mo_3O_{10})_4]$ x $H_2O$, 1,4 g $CuSO_4.5\ H_2O$ sowie 1,4 g $MoO_3$. Nachdem man bei 110° C 90 Stunden lang Druckluft durchgeleitet hatte, wurde das Reaktionsgemisch bei einer Temperatur von 80° C portionsweise in 4 l siedendes n-Hexan gegeben. Dann wurde abfiltriert und das Filtrat am Rotationsverdampfer eingeengt. Das nach einer Destillation bei einer Übergangstemperatur von 97° C/13 mbar als gelbliches Öl anfallende Produkt wurde durch Zusatz von 10 Vol.-% n-Hexan bei -18° C in fast farblose Kristalle übergeführt.

Ausbeute: 183,8 g (47 % der Theorie).

Beispiel 2

3,3,5-Trimethylcyclohex-5-en-1,2,4-trion

129,4 g 2,6,6,-Trimethylcyclohex-2-en-1,4-dion (aus Beispiel 1) wurden zu einer Lösung von 100 g Selendioxid in einem Gemisch aus 800 ml Dioxan und 50 ml Wasser gegeben und 9 Stunden unter Rühren unter Rückfluß erhitzt. Man nutschte von elementar abgeschiedenem Selen ab und zog anschließend am Rotationsverdampfer alle niederflüchtigen Komponenten ab. Der Rückstand wurde bei 125° C/20 mbar destilliert. Das Destillat wurde aufgeschmolzen, unter n-Hexan gemörsert und dann mit 600 ml n-Hexan extrahiert. Das Zielprodukt kristallisierte in Form von gelben Nädelchen aus.

Ausbeute: 97,9 g (69% der Theorie); Schmp.: 88° C.

Beispiel 3

Bis(3-hydroxy-5,5-dimethyl-4,6-dioxocyclohex-2-enyliden)ethan

In einem mit Intensivkühler und Rührer bestückten 2 l Dreihalskolben löste man bei Raumtemperatur 50 g 3,3,5-Trimethylcyclohex-5-en-1,2,4-trion (aus Beispiel 2) in 300 ml konz. Salzsäure. Dann tauchte man den Kolben 15 Minuten in ein auf 100° C vorgeheiztes Ölbad, dabei färbte sich das Reaktionsgemisch dunkel und ein orangefarbener Festkörper schied sich ab. Dieser wurde noch warm abgenutscht und mit Wasser, Ethanol, Aceton, Essigsäureethylester und Ether gewaschen. Das resultierende Produkt wurde im Exsiccator von anhaftenden Resten Lösungsmittel befreit. (Es ist so für alle weiteren Umsetzungen rein genug. Gegebenenfalls kann es aus Dioxan umkristallisiert werden.)

Ausbeute: 15,5 g (31 % der Theorie), Zers.pkt. 270° C

$C_{18}H_{18}O_6$, M = 330,3,

| | | |
|---|---|---|
| Elementaranalyse: Ber. | C 65,45 | H 5,49 |
| | C 65,73 | H 5,62 |

$^1$H-NMR$_{300}$(d$_6$-DMSO/TMS):

$\delta$ = 1,29 (s; 12H, Me$_2$), 7,27, 7,28 (2x s; 2 x 2H, 2-H, $\alpha$-H), 10,15 (bs; 2H, OH)

Zudem treten die Signale eines anderen Doppelbindungsisomeren auf:

UV-Vis(Dioxan):

$\lambda_{max}$ = 440, 421sh, 248 nm

IR (fest, KBr):

$\tilde{\nu}$ = 3360 (OH), 3095 (= C-H), 3030 (= C-H), 2990 ($CH_3$), 2940 ($CH_3$), 2870 ($CH_3$), 1675 (C=O), 1652 (C=C=C=O), 1623 cm$^{-1}$ (C=C).

Beispiel 4

Bis(3-acetoxy-5,5-dimethyl-4,6-dioxocyclohex-2-enyliden)ethan

In 15 ml Pyridin löste man 2 g Bis(3-hydroxy-5,5-dimethyl-4,6-dioxocyclohex-2-enyliden)ethan (aus Beispiel 3) und setzte 6 ml Acetanhydrid zu. Nach 10 minütigem Rühren schied sich ein gelbgrüner Niederschlag ab, der nach 1 Stunde abgenutscht und mit Ether gewaschen wurde. Das Rohprodukt wurde zweimal aus Chloroform umkristallisiert, wobei man ein grünstichig gelbes Pulver erhielt.

Ausbeute: 1,5 g (60 % der Theorie) Schmp.: 210° C

$C_{22}H_{22}O_8$, M = 414,4,

| | | |
|---|---|---|
| Elementaranalyse: Ber. | C 63,76 | H 5,35 |
| Gef. | C 65,49 | H 5,36 |

$^1$H-NMR$_{300}$(CDCl$_3$/TMS):

$\delta$ = 1,44 (s; 12H, Me$_2$), 2,33 (s; 6H, OAc), 7,63 (s; 2H, $\alpha$-H), 7,65 (s; 2H, 2-H)

UV-Vis (CHCl$_3$):

$\lambda_{max}$ = 388, 250 nm

IR (fest, KBr):

$\tilde{\nu}$ = 2980 (=CH), 2935 ($CH_3$), 1765 (COOAc), 1700 (C=O), 1675 (C=O), 1180 (C-O-C), 1030 cm$^{-1}$ (C-O-C)

Beispiel 5

Bis(3-benzoyloxy-5,5-dimethyl-4,6-dioxocyclohex-2-enyliden)ethan

Zu einer Lösung von 2 g Bis(3-hydroxy-5,5-dimethyl-4,6-dioxocyclohex-2-enyliden)ethan (aus Beispiel 3) in 15 ml Pyridin gab man 8 ml Benzoylchlorid. Aus dem sich von selbst erwärmenden Ansatz schied sich innerhalb von 2 Stunden ein schmutzig gelber Niederschlag ab, der abgenutscht und mit Ether

gewaschen wurde. Das Rohprodukt wurde zweimal aus Chloroform umkristallisiert, wodurch man verfilzte gelbe Nadeln erhielt.

Ausbeute: 1,1 g (34 % der Theorie), Schmp.: 224° C

$C_{32}H_{26}O_8$, M = 538,55,

| | | |
|---|---|---|
| Elementaranalyse: Ber. | C 71,37 | H 4,87 |
| Gef. | C 71,44 | H 4,98 |

$^1$H-NMR$_{300}$($CDCl_3$/TMS):

$\delta$ = 1,50 (s; 12H, $Me_2$), 7,53 (tm; 4H, 3′-H, 5′-H), 7,68 (tm; 2H, 4′-H), 7,71 (s; 2H, $\alpha$-H), 7,83 (s; 2H, 2-H), 8,14 (m; 4H, 2′-H, 6′-H)

UV-Vis ($CHCl_3$)

$\lambda_{max}$ = 392, 285, 277 nm

IR (fest, KBr):

$\tilde{\nu}$ = 2980 ($CH_3$), 1735 (COOBz), 1695 (C=O), 1665 (C=O), 1250 (C-O-C), 1055 $cm^{-1}$ (C-O-C)

Beispiel 6

Bis(3-methoxy-5,5-dimethyl-4,6-dioxocyclohex-2-enyliden)ethan

In einem Gemisch aus 240 ml Dioxan und 240 ml Acetonitril wurde unter Stickstoff 4 g Bis(3-hydroxy-5,5-dimethyl-4,6-dioxocyclohex-2-enyliden)ethan (aus Beispiel 3) durch Erhitzen unter Rückfluß aufgelöst. Dann wurden 16 g Dimethylsulfat und anschließend 12 g fein gemörsertes wasserfreies Kaliumcarbonat zugesetzt. Der sich sofort grünblau verfärbende Ansatz heilte im Laufe einer Stunde während Erhitzen unter Rückfluß nach gelb auf. Das Reaktionsgemisch wurde heiß filtriert, der Filterkuchen mit Acetonitril gewaschen und die vereinigten organischen Phasen am Rotationsverdampfer eingeengt. Die Reste an Alkylierungsmittel wurden durch Digerieren mit Ether, die unlöslichen Bestandteile durch Erhitzen in Chloroform entfernt. Das Filtrat wurde eingeengt und der Rückstand mehrfach aus Aceton umkristallisiert. Man erhielt einen Feststoff in Form von rotstichig gelben Prismen.

Ausbeute: 1,4 g (32 % der Theorie), Schmp.: 247° C

$C_{20}H_{22}O_6$, M = 358,4,

| | | |
|---|---|---|
| Elementaranalyse: Ber. | C 67,03 | H 6,19 |
| Gef. | C 66,74 | H 5,91 |

$^1$H-NMR$_{300}$($CD_2Cl_2$/TMS):

$\delta$ = 1,38 (s; $Me_2$), 3,90 (s; 6H, OMe), 7,05, 7,48 (2 x s; 2 x 2H, 2-H, $\alpha$-H)

UV-Vis ($CHCl_3$):

$\lambda_{max}$ = 433, 240 nm

IR (fest, KBr):

$\tilde{\nu}$ = 3060 (=CH), 2960 ($CH_3$), 2930 ($CH_3$), 2835 ($OCH_3$), 1690 (C=O), 1665 (C=O), 1595 (C=C), 1220 (=C-O-C), 1050 $cm^{-1}$ (=C-O-C)

Beispiel 7

Bis(5,5-dimethyl-3-trimethylsiloxy-4,6-dioxocyclohex-2-enyliden)ethan

Unter Feuchtigkeitsausschluß erhitzte man eine Suspension von 1 g Bis(3-hydroxy-5,5-dimethyl-4,6-dioxocyclohex-2-enyliden)ethan (aus Beispiel 3) in 50 ml absolutem Essigsäureethylester mit 10 ml Hexamethyldisilazan [$(Me_3Si)_2NH$] unter Rückfluß. Aus der nach 40 minütigem Erhitzen entstandenen

Lösung destillierte man im Wasserstrahlvakuum unter Zwischenschaltung eines mit KOH gefüllten Trockenturmes die Lösungsmittel ab.

Sobald sich in der Hitze das Rohprodukt kristallin abschied, nutschte man über eine warme Fritte ab und wusch mit viel kaltem n-Hexan nach. Kristallisation aus 10 ml absolutem n-Hexan pro 0,1 g Rohprodukt ergab im Tiefkühlschrank das Zielprodukt in Form von rötlich orangen Kristallen.

Ausbeute: 1,1 g (74 % der Theorie), Zersp.: 170 °C
$C_{24}H_{34}O_6Si_2$, M = 474,7,

| | | |
|---|---|---|
| Elementaranalyse: Ber. | C 60,73 | H 7,22 |
| Gef. | C 60,49 | H 7,30 |

$^1$H-NMR$_{300}$(CDCl$_3$/TMS):
$\delta$ = 0,30 (s; 24H, Me$_3$Si), 1,40 (s; 12H, Me$_2$), 7,33 (s; 2H, 2-H), 7,42 (s; 2H, $\alpha$-H)
Zudem treten Signale eines anderen Doppelbindungsisomeren auf.

UV-Vis (Dioxan):
$\lambda_{max}$ = 440, 420sh nm
IR (Lösung, $CCl_4$):
$\tilde{\nu}$ = 2950 ($CH_3$), 1685 (C=O), 1665 (C=O), 1590 cm$^{-1}$ (C=0)

Beispiel 8

Bis(3-N-cyclohexylamino-5,5-dimethyl-4,6-dioxocyclohexyliden)ethan

Unter Zusatz einer für das Lösen des intermediär gebildeten Salzes ausreichenden Menge Essigsäure löste man 6 g Cyclohexylamin in 40 ml Dioxan. Diese Mischung gab man zu einer Lösung von 10 g 3,3,5-Trimethylcyclohex-5-en-1,2,4-trion (aus Beispiel 2) in 40 ml Dioxan. Man beließ 45 Minuten bei Raumtemperatur und goß anschließend das rotviolett gefärbte Reaktionsgemisch unter kräftigem Rühren in 600 ml Wasser. Die sich abscheidenden Plättchen wurden abgenutscht und mit wenig Methanol gewaschen. Das Rohprodukt wurde durch einmaliges Umfällen aus Dioxan gereinigt und dann im Exsiccator getrocknet.

Ausbeute: 0,6 g (4 % der Theorie), Zersp.: 250 °C
$C_{30}H_{40}N_2O_4$, M = 492,7,

| | | | |
|---|---|---|---|
| Elementaranalyse: Ber. | C 73,14 | H 8,18 | N 5,69 |
| Gef. | C 72,98 | H 8,22 | N 5,72 |

$^1$H-NMR$_{300}$(d$_{18}$-HMPT/TMS):
$\delta$ = 0,8 - 2,0 (bm; 20H, 2'-H, 3'-H, 4'-H, 5'-H, 6'-H), 1,30 (s; 12H, Me$_2$), 3,40 (bs; 2H, 1'-H), 6,52, 7,08 (2 x s; 2 x 2H, 2-H, $\alpha$-H), 10,60 (bs; 2H, NH)
Zudem treten Signale weiterer Doppelbindungsisomerer auf.

UV-Vis (Dioxan):
$\lambda_{max}$ = 536 nm
IR (fest, KBr):
$\tilde{\nu}$ = 3340 (NH), 2960 ($CH_3$), 2850 ($CH_3$), 1650 (C=0), 1580 cm$^{-1}$ (C=C)

MS (70 eV):
m/e (%) = 492 (100, M$^+$), 477 (11, M - Me), 462 (3, M - 2 Me), 409 (16, M - $C_6H_{11}$), 246 (5, M/2)

Beispiel 9

Bis(3-anilino-5,5-dimethyl-4,6-dioxocyclohex-2-enyliden)ethan

In 20 ml Dioxan vereinigte man 2,82 g Anilin und 5,1 g Trifluoressigsäure. Dieses Gemisch gab man zu einer Lösung von 5 g 3,3,5-Trimethylcyclohex-5-en-1,2,4-trion (aus Beispiel 2) in 20 ml Dioxan. Der sich rasch rotviolett verfärbende Ansatz wurde nach 90 Minuten unter heftigem Rühren in 400 ml Wasser gegossen. Das sich abscheidende Rohprodukt wurde abgenutscht, mit Ethanol und Ether gewaschen und aus 30 ml siedendem Dioxan umkristallisiert, wobei man dunkelviolette, metallisch glänzende Plättchen erhielt.

Ausbeute: 1,9 g (26 % der Theorie), Zersp. >300 ° C.

$C_{30}H_{28}N_2O_4$, M = 480,6,

| | | | |
|---|---|---|---|
| Elementaranalyse: Ber. | C 74,98 | H 5,87 | N 5,83 |
| Gef. | C 75,24 | H 5,65 | N 5,86 |

$^1H$-$NMR_{300}$($d_{18}$-HMPT/TMS):

$\delta$ = 1,35 (s; 12H, $Me_2$), 6,9 - 7,5 (m, 2-H, α-H, $C_6H_5$)

UV-Vis (Dioxan):

$\lambda_{max}$ = 555 nm

UV-Vis ($CHCl_3$):

$\lambda_{max}$ = 564 nm

UV-Vis (DMF):

$\lambda_{max}$ = 572 nm

IR (fest, KBr):

$\tilde{\nu}$ = 3320 (NH), 2980 ($CH_3$), 1680 (C=O), 1650 (C=O), 1575 $cm^{-1}$ (C=C)

In analoger Weise werden die in der folgenden Tabelle 1 aufgeführten Farbstoffe der Formel

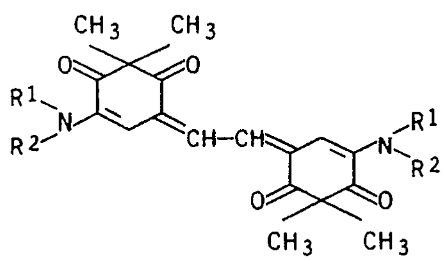

erhalten.

Tabelle 1

| Beispiel Nr. | $R^1$ | $R^2$ | Säure | $\lambda_{max}$ [nm] ($CHCl_3$) |
|---|---|---|---|---|
| 10 | n-$C_4H_9$ | H | $CH_3$-COOH | 540 |
| 11 | -$(CH_2)_5$- | | $CH_3$-COOH | 552 |
| 12 | p-Tolyl | H | $CF_3$-COOH | 570 |
| 13 | Naphth-1-yl | H | $CF_3$-COOH | 582 |
| 14 | $CH_2$-$C_6H_5$ | H | $CF_3$-COOH | 548 |
| 15 | n-$C_4H_9$ | $CH_3$ | $CH_3$-COOH | 542 |
| 16 | -$CH_2$-$CH_2$-O-$CH_2$-$CH_2$- | | $CH_3$-COOH | 550 |
| 17 | -$CH_2$-$CH_2$-$C_6H_5$ | H | H-COOH | 550 |
| 18 | Cyclo-$C_5H_9$ | H | $CH_3$-COOCH | 540 |

Beispiel 19

Bis(1,1-dimethyl-2-oxo-5-phenyl-1,2,5-trihydrophenaz-3-enyliden)ethan

Eine Lösung von 3,3 g N-Phenylphenylen-1,2-diamin in 25 ml Dioxan und 5 ml Trifluoressigsäure wurde zu einer Lösung von 3 g 3,3,5-Trimethylcyclohex-5-en-1,2,4-trion (aus Beispiel 2) in 35 ml Dioxan gegeben. Den sich blaugrün verfärbenden Ansatz ließ man noch 1 Stunde bei Raumtemperatur rühren, wobei das Zielprodukt bereits weitgehend ausfiel. Nachdem man die Suspension unter intensivem Rühren in 500 ml Wasser gegossen hatte, wurde der grüne Niederschlag abgenutscht und mit Ethanol und Ether gewaschen. Nach Kristallisation aus Chlorbenzol erhielt man das Zielprodukt in Form grüner, metallisch glänzender Plättchen.

Ausbeute: 4,2 g (74 % der Theorie), Schmp.: >280 ° C

$C_{42}H_{34}N_4O_2$, M = 626,75,

| | | | |
|---|---|---|---|
| Elementaranalyse: Ber. | C 80,49 | H 5,47 | N 8,94 |
| Gef. | C 80,62 | H 5,54 | N 8,64 |

UV-Vis (Dioxan):

$\lambda_{max}$ = 640, 328, 251 nm

UV-Vis ($MeCONMe_2$):

$\lambda_{max}$ = 648 nm

IR (fest, KBr):

$\tilde{\nu}$ = 1670 (C=O), 1540 $cm^{-1}$ (C=N

In analoger Weise werden die in der folgenden Tabelle 2 aufgeführten Farbstoffe der Formel

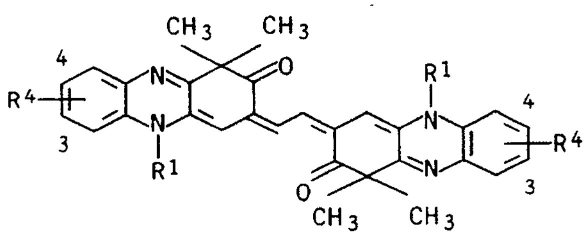

erhalten.

Tabelle 2

| Beispiel Nr. | $R^1$ | $R^4$ |
|---|---|---|
| 20 | $C_2H_5$ | H |
| 21 | Cyclo-$C_6H_{11}$ | H |
| 22 | $CH_2$-$C_6H_5$ | 3-$CH_3$ |
| 23 | $C_6H_5$ | 3-$CH_3O$ |
| 24 | Cyclo-$C_6H_{11}$ | 3-$CH_3O$ |
| 25 | $C_6H_5$ | 3-Cl |
| 26 | $C_2H_5$ | 3-Cl |
| 27 | $CH_2$-$C_6H_5$ | 4-$CH_3$ |
| 28 | $C_6H_5$ | 4-$CH_3O$ |
| 29 | cyclo-$C_6H_{11}$ | 4-$CH_3O$ |
| 30 | $C_6H_5$ | 4-Cl |
| 31 | $C_6H_5$ | 4-Cl |

## Ansprüche

1. Cycloalkylidenfarbstoffe der Formel I

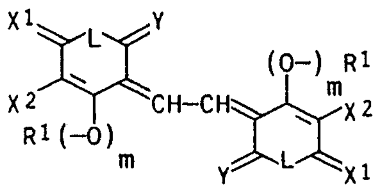

(I),

in der
m 0 oder 1,
L eine chemische Bindung oder $C_1$-$C_2$-Alkylen, das gegebenenfalls durch $C_1$-$C_4$-Alkyl ein- oder zweifach substituiert ist,
$R^1$ Wasserstoff, $C_1$-$C_{20}$-Alkyl, das gegebenenfalls durch Phenyl substituiert ist, gegebenenfalls substituiertes Phenyl, Naphthyl oder $C_3$-$C_7$-Cycloalkyl,
Y Sauerstoff oder zweimal Wasserstoff,
$X^1$ Sauerstoff und
$X^2$ $C_1$-$C_8$-Alkanoyloxy, gegebenenfalls substituiertes Benzoyloxy, $C_1$-$C_6$-Trialkylsilyloxy oder einen Rest der Formel $OR^1$ oder $NR^2R^3$, wobei $R^1$ die obengenannte Bedeutung besitzt und $R^2$ und $R^3$ gleich oder verschieden sind und unabhängig voneinander jeweils für $C_1$-$C_{20}$-Alkyl, das gegebenenfalls durch Phenyl substituiert ist, gegebenenfalls substituiertes Phenyl, Naphthyl oder $C_3$-$C_7$-Cycloalkyl oder $R^2$ und $R^3$ zusammen mit dem sie verbindenden Stickstoffatom für einen 5- oder 6-gliedrigen gesättigten heterocyclischen Rest, der gegebenenfalls weitere Heteroatome aufweist, oder einer der beiden Reste $R^2$ und $R^3$ auch für Wasserstoff stehen, oder $X^1$ und $X^2$ zusammen einen Rest der Formel

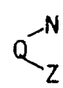

bedeuten, worin
Z für Sauerstoff, Schwefel oder $NR^2$, wobei $R^2$ die obengenannte Bedeutung besitzt, und
Q für einen 5- oder 6-gliedrigen gesättigten oder aromatischen, carbocyclischen oder heterocyclischen Ring, an dem die Substituenten N und Z benachbarte Ringpositionen einnehmen, stehen.

2. Cycloalkylidenfarbstoffe nach Anspruch 1, dadurch gekennzeichnet, daß L eine chemische Bindung oder Prop-2-yliden bedeutet.

3. Cycloalkylidenfarbstoffe nach Anspruch 1, die die Formel II

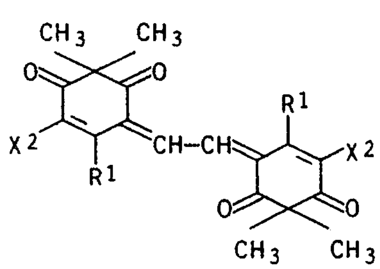

(II)

aufweisen,
in der
$R^1$ Wasserstoff, $C_1$-$C_{10}$-Alkyl, das gegebenenfalls durch Phenyl substituiert ist, Phenyl oder Naphthyl bedeutet und

$X^2$ die in Anspruch 1 genannte Bedeutung besitzt.

4. Cycloalkylidenfarbstoffe nach Anspruch 1, die die Formel III

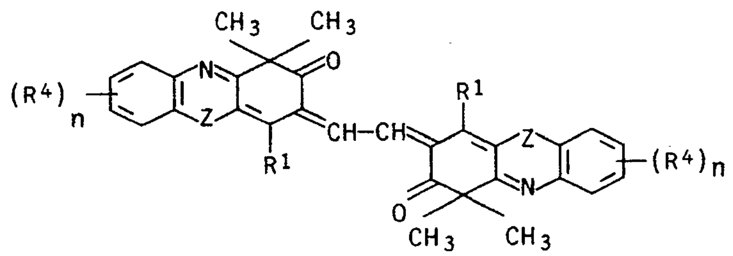

(III)

aufweisen,
in der
n 1, 2, 3 oder 4,
$R^1$ Wasserstoff, $C_1$-$C_{10}$-Alkyl, das gegebenenfalls durch Phenyl substituiert ist, Phenyl oder Naphthyl und
$R^4$ $C_1$-$C_{10}$-Alkyl, $C_1$-$C_{10}$-Alkoxy, Nitro, Amino, $C_1$-$C_4$-Mono- oder Dialkylamino, Pyrrolidino, Piperidino, Morpholino, Piperazino, N-($C_1$-$C_4$-Alkyl)piperazino oder Halogen bedeuten und
Z die in Anspruch 1 genannte Bedeutung besitzt.